# EUROPÄISCHE PATENTSCHRIFT

(11) **EP 0 669 408 B1**
(45) Veröffentlichungstag und Bekanntmachung des Hinweises auf die Patenterteilung: **12.05.1999**
(21) Anmeldenummer: 95101843.1
(22) Anmeldetag: 10.02.1995
(51) Int. Cl.: C23C 16/26

(54) **Verfahren zur Herstellung von Diamantschichten**
Process for forming diamond coatings
Procédé de dépôt de couches de diamant

(30) Priorität: 23.02.1994 DE 4405871; 29.03.1994 DE 4410936
(43) Veröffentlichungstag der Anmeldung: 30.08.1995
(73) Patentinhaber: Linde Aktiengesellschaft, 65189 Wiesbaden (DE)
(72) Erfinder: Werner, Stefan, Dipl.-Ing., D-84183 Niederviehbach (DE); Volz, Bernhard, Dipl.-Ing., D-81827 München (DE); Tischler, Friedrich, A-4650 Lambach (DE)
(74) Vertreter: Kasseckert, Rainer

(56) Entgegenhaltungen:
- EP-A- 0 324 538
- EP-A- 0 376 694
- DE-A- 3 825 721
- DATABASE WPI Section Ch, Week 9024 Derwent Publications Ltd., London, GB; Class E36, AN 90-182541 & JP-A-02 120 219 ( SUMITOMO METAL MINI KK) , 8.Mai 1990
- PATENT ABSTRACTS OF JAPAN vol. 013 no. 115 (C-578) ,20.März 1989 & JP-A-63 288993 (SUMITOMO ELECTRIC IND LTD) 25.November 1988,
- PATENT ABSTRACTS OF JAPAN vol. 013 no. 413 (E-820) ,12.September 1989 & JP-A-01 152621 (SEMICONDUCTOR ENERGY LAB CO LTD) 15.Juni 1989,
- JOURNAL OF APPLIED PHYSICS, 1 SEPT. 1993, USA, Bd. 74, Nr. 5, ISSN 0021-8979, Seiten 3531-3533, ABE T ET AL 'Formation of highly uniform and dense diamond microcrystal thin films using a combustion flame surrounded by an inert-gas flow'

## Beschreibung

Die Erfindung betrifft ein Verfahren zur Herstellung von Diamantschichten, bei dem die Diamantschicht auf einem Substrat mittels eines durch Energieeintrag erzeugten Plasmas aus einem Basisgas, das zumindest Wasserstoff und ein eine Dreifachbindung enthaltendes Kohlenwasserstoffgas (Alkingas), insbesondere Acetylen, sowie optionsweise zusätzlich auch Edelgas enthält, gebildet wird, wobei dieser Bildungsprozeß bei einem Gasdruck von 0,05 hPa (mbar) bis atmosphärischen Druck, vorzugsweise bei einem Gasdruck von 0,05 bis 500 hPa (mbar), und bei einer Temperatur des Substrats von 300 bis 1000°C ausgeführt wird.

Ein solches Verfahren, das speziell mit einer Plasmabildung auf der Basis einer Gleichstromentladung arbeitet, ist beispielsweise aus der DE-OS 42 22 406 bekannt. Dort ist der Kohlenstoff enthaltende Bestandteil des Basisgases insbesondere Methan. Neben diesen Verfahren, die mit einer Plasmabildung mittels einer Gleichstromentladung arbeiten, sind grundsätzlich auch Verfahren mit anderen Plasmabildungsmechanismen bekannt, insbesondere sei hierbei auf die mit Plasmabrennem arbeitenden Verfahren hingewiesen.

Aus der EP-A-0 376 694 sind Lichtbogenverfahren, Mikrowellen-PCVD-Verfahren sowie Glimmentladungsverfahren zur Herstellung von Diamantschichten auf einem Substrat bekannt. Hierzu wird eine geeignete Mischung eines Wasserstoff enthaltenden Gases, eines Inertgases, eines Kohlenstoff enthaltenden Gases und eines Sauerstoff enthaltenden Gases in einen Reaktor eingebracht, in dem anschließend durch ein elektrisches Feld ein Plasma erzeugt wird. Als Kohlenstoff enthaltendes Gas wird unter anderem auch das eine Dreifachbindung enthaltende Acetylen angeführt.

In der Zusammenfassung der JP-A-63-288 993 in den Patent Abstracts of Japan wird ein Verfahren zum Diamantabscheiden beschrieben, bei dem ein Kohlenwasserstoff, wie z. B. Acetylen, unter dem Einfluß eines UV-Lasers zersetzt wird, so daß sich ein dünner Diamantfilm auf dem Substrat abscheidet.

Die Aufgabenstellung bei der vorliegenden Erfindung bestand darin, ein effizientes, im Vergleich zu bekannten Verfahren möglichst leistungsstärkeres und andererseits von den Betriebs- und Investitionskosten her dennoch vertretbares Verfahren zur Diamantabscheidung vorzuschlagen.

Diese Aufgabe wird erfindungsgemäß dadurch gelöst, daß die Zumischung des die Dreifachbindung enthaltenden Kohlenwasserstoffgases zum Basisgas oder einem Anteil des Basisgases innerhalb der Kammer oder in der Zuleitung zur Kammer von einer vorausgehenden und einer nachfolgenden Inertgaszumischung begleitet ausgeführt wird, wobei die Umschaltung zwischen Inertgaszumischung und Kohlenwasserstoffgaszumischung in einem weichen, nicht plötzlich erfolgenden Wechsel insbesondere ohne wesentlichen Drucksprung erfolgt.

Ein grundlegender Vorteil der Dreifachbindungen enthaltenden Kohlenwasserstoffgase gegenüber anderen Kohlenwasserstoffgasen, z.B. Methan, besteht darin, daß in ihnen pro Molekül ein höherer Kohlenstoffatomanteil enthalten ist. Dieser hohe Kohlen- stoffanteil ist bei der Diamantbildung hinsichtlich der Effizienz der Bildung von grundsätzlichem Vorteil. Außerdem ergeben - wie sich bei der Ausführung der Erfindung zeigt - Dreifachbindungen enthaltende Kohlenwasserstoffgase, wenn sie unter Abtrennung der Wasserstoffatome niedergeschlagen werden, einen offenbar für die Diamantbildung besonders günstigen Ausgangsstoff. Dies ist wahrscheinlich auf die dreifachbindige Struktur dieser Verbindungen zurückführbar.

Demgegenüber steht jedoch das Sicherheitsproblem, das mit den an sich instabilen, gasförmigen Alkinen einhergeht, da diese, selbst ohne Anwesenheit von Sauerstoff, in einer heftigen Reaktion zerfallen können. Bei der vorliegenden Erfindung bedeutet dies, daß der erfindungsgemäße Zumischvorgang so ausgestaltet wird, daß Drucksprünge, abrupte Schaltvorgänge sowie plötzliche Konzentrationsänderungen hinsichtlich des Alkingases und gegebenenfalls vorhandener Begleitgase vermieden werden.

Erfindungsgemäß wird die Zumischung des die Dreifachbindung enthaltenden Kohlenwasserstoffgases (= KW-Gases) zum Basisgas oder einem Anteil des Basisgases innerhalb der Kammer oder in der Zuleitung zur Kammer von einer vorausgehenden und einer nachfolgenden Inertgaszumischung begleitet ausgeführt wird, wobei die Umschaltung zwischen der Inertgaszumischung und der KW-Gaszumischung in einem weichen, nicht plötzlich erfolgenden Übergang, insbesondere ohne wesentlichen Drucksprung, erfolgt.

Eine vorteilhaft kontrollierte Zu- und Abschaltung der Zumischung des KW-Gases und gegebenenfalls eines Begleitgases wird dadurch erhalten, daß in die der KW-Gaszuleitung dienenden, mit einem Rückschlagventil ausgestatteten Versorgungsleitung - und gegebenenfalls auch in die ebenfalls mit einem Rückschlagventil versehene Zuleitung für das Begleitgas - stromabwärts der Rückschlagventile ein Inertgas derart eingeleitet wird, daß das Inertgas auf ein jeweils geringfügig höheres Druckniveau eingestellt ist als das der jeweiligen Versorgungsleitung zugeführte Gas, wobei bei beabsichtigter Einschaltung des Zumischvorgangs des KW-Gases zur Plasmakammer anfänglich die Inertgaszuleitung zu den Versorgungsleitungen offen geschaltet ist, der deshalb erfolgende Inertgaszustrom jedoch nach kurzer Zeit durch die Schließung der Inertgaszuleitung beendet wird und auf diese Weise die KW-Gaszufuhr durch die sich öffnenden Rückschlagventile einsetzt, und bei dem die Abschaltung der KW-Gas-Zufuhr dadurch erfolgt, daß die besagte Inertgaszufuhr mit den besagten Druckverhältnissen wieder begonnen wird.

Vorteilhafte Grundvarianten der Erfindung bestehen ferner darin, daß die Diamant-schicht auf dem Substrat entweder mittels eines darauf gerichteten, mit einem Lichtbogen erzeugten Plasmagasstromes aus Basisgas gebildet wird, wobei Druckwerte von 100 bis 500 hPa (mbar) eingestellt werden, oder daß die Diamantschichtbildung auf dem Substrat mittels eines durch eine Gleichstromentladung gebildeten oder mittels eines mit elektromagnetischen Wellen erzeugten Plasmas ebenfalls aus einer Basisgasmischung erfolgt, wobei in diesen Varianten ein Niederdruck von unterhalb 50 hPa (mbar) vorteilhaft geeignet ist (vgl. DE-OS 42 22 406).

Als besonders geeignet erweist sich eine Diamantbeschichtung mittels eines sogenannten Plasma-Jets, der von einem durch eine düsenförmige Elektrodenanordnung strömenden Gas gebildet wird. Durch Bogenentladung im düsenförmigen Teil dieser Elektrodenanordnung wird aus dem zuströmenden Gas ein Plasma gebildet, das zu dem gekühlten Substrat geführt wird, auf dem sich eine Diamantschicht abscheidet. Die Elektrodenanordnung besteht zumeist aus einer wassergekühlten Düse, innerhalb derer sich eine spitz zulaufende zylindrische oder eine flächenhafte Elektrode befindet. Düse und Elektrode befinden sich unter elektrischer Spannung, die im Gas zu einer Bogenentladung führt, wobei das entstehende Plasma als Lichtbogen sichtbar ist. Als das Plasma erzeugende Gas werden aufgrund ihres Ionisierungspotentials und ihrer inerten Eigenschaften zumeist Edelgase, wie Argon, Neon und/oder Helium, verwendet, die als Trägergas für das kohlenstoffhaltige Gas fungieren. Die Plasmabildung kann außerdem durch ein Gas wie Fluor beschleunigt werden.

Wasserstoff und Sauerstoff werden dem Plasma ebenfalls zugeführt, um als selektive Ätzmittel amorphen Kohlenstoff und Graphit aus der Diamantschicht zu entfernen.

Der Plasmagasstrom wird hierbei in vorteilhafter Weise aus einem oder mehreren Gasströmen gebildet, wobei diese Gasströme beispielsweise jeweils als Trägergas ein Edelgas, wie Argon oder Helium oder eine Mischung davon enthalten, wobei einem Trägergasstrom erfindungsgemäß ein Alkingas wie Acetylen oder Sauerstoff oder Wasserstoff zugemischt sein kann. Diese Zumischung geringer Mengen eines der zuletzt genannten Gase in einen Trägergasstrom ist mit hoher Genauigkeit mittels einer Mischvorrichtung möglich. Hierbei wird dem Trägergas das zugesetzte Gas (z.B. Wasserstoff oder Acetylen) zunächst durch Einwiegen in höherer Konzentration zugegeben und anschließend ebenfalls gravimetrisch durch Zugabe weiteren Trägergases die gewünschten Konzentrationsverhältnisse in der Gasmischung herbeigeführt. Die Konzentration des zugegebenen Gases im Trägergas kann auf diese Weise sehr genau und zeitlich konstant gehalten werden.

Mittels einer weiteren Mischvorrichtung lassen sich zwei Trägergasströme mit genau bestimmten Beimengungen an den jeweils zugesetzten Gasen zu einem Gasstrom mischen.

Als besonders geeignet erweist sich ein Gasstrom aus Argon als Trägergas mit einer Zumischung von 100 bis 200 ppm Acetylen, wobei in diesem Gasstrom ein Lichtbogen gezündet wird. Ein weiterer Gasstrom kann aus Argon und zugemischten Sauerstoff oder Wasserstoff gebildet werden, der ebenfalls dem Plasma zugeleitet wird. Die genannten Mengen Acetylen führen bei der erwähnten Elektrodenanordnung nicht zu einer die Elektroden schädigenden Wirkung, können genau dosiert werden und führen zu hohen Diamantschichtqualitäten.

Zusätzlich kann in einer geeigneten Variante der Plasmagasstrom von einem Außenschutzgas umgeben sein, das Gase der umgebenden Atmosphäre femhält und gleichzeitig auch eine Ätzwirkung für die Nicht-Diamantbestandteile aufweisen kann. Als vorteilhaftes Außenschutzgas ist hierbei Argon mit Wasserstoff hervor-zuheben.

Ein weiteres plasmaunterstütztes CVD-Verfahren stellt die Gleichstrom-Glimmentladung dar, bei der mittels einer Gleichspannung in einer Niedrigdruck-Gasatmosphäre bei 0,05 bis 50 hPa (mbar) ein Plasma erzeugt wird. Die beschichteten Flächen sind mit ca. 80 cm² relativ groß. Vorteilhaft ist bei Verwendung von Acetylen als Alkingas eine Konzentration von 0,1 bis 1,0 Vol.-%, besser unterhalb 0,5 Vol.-%, in Argon.

Schließlich sei noch die Möglichkeit hervorgehoben, mit einem herkömmlichen Laserschweißverfahren ein Plasma zu erzeugen, aus dem sich Diamantschichten abscheiden lassen. Beim Laserschweißen unter dem Schutzgas Argon beobachtet man schon bei relativ niedrigen Leistungsdichten die Bildung eines thermisch induzierten Plasmas, das aufgrund der Energieabsorption durch die erhöhte Teilchenzahl den weiteren Schweißvorgang behindert. Diesen beim Schweißen nachteiligen Effekt kann man zur Diamantbildung gezielt einsetzen.

Insbesondere bei den Verfahren zur Diamantabscheidung durch Plasma-Jets oder durch Laserstrahlung kann die Abscheiderate durch Ansteigen des Drucks in der Arbeitskammer auf Werte in der Nähe von atmosphärischen Druck erhöht werden.

Im folgenden wird die Erfindung anhand von Ausführungsbeispielen unter Zuhilfenahme der beigefügten Zeichnungen näher erläutert. Hierzu zeigt:
- Figur 1: schematisch eine Gesamtanordnung zur Ausführung der Erfindung;
- Figur 2: eine geeignete Schaltung für die Zufuhr des Kohlenwasserstoffgases;
- Figur 3: schematisch eine zur Erzeugung eines Plasma-Jets für die Diamantbeschichtung geeignete Vorrichtung.

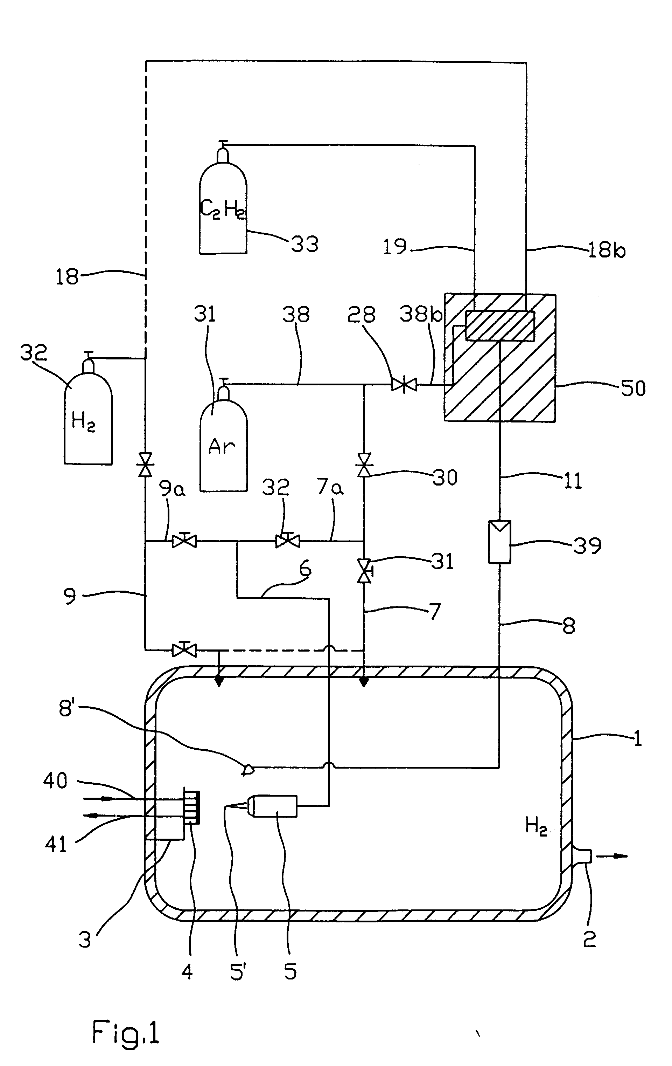

In **Figur 1** ist zunächst eine Kammer 1 erkennbar, die mit einer Abzugsöffnung 2 ausgestattet ist, über die das für den auszuführenden Prozeß notwendige Vakuum in der Kammer hergestellbar ist. Des weiteren ist in der Kammer 1 ein Substrathalter 3 an einer Kammerwand montiert und auf diesem ein Substrat 4 befestigt. Vor dem Substrat und auf dieses gerichtet ist im gezeigten Fall in einem Abstand von 5 bis 30 cm ein der Plasma- und Wärmeerzeugung dienender Plasmabrenner 5 angeordnet. Dem Plasmabrenner 5 ist über eine Leitung 6 ein Argon-Wasserstoff-Plasmagas zuführbar. Des weiteren ist eine Zuleitung 8 vorgesehen, die der Zufuhr von Acetylen oder einer Acetylen-Wasserstoff-Mischung zur Kammer 1 und insbesondere zu der vom Plasmabrenner 5 gebildeten Plasmaflamme 5' dient. Ebenso sind weitere Zuleitungen 7 und 9 für die jeweils eigenständige Zufuhr von Argon und Wasserstoff zur Kammer 1 vorgesehen.

Durch den Plasmabrenner 5 und dessen Flamme wird im Betrieb eine sehr hohe Temperatur im Raum zwischen Brenner und Substrat 4 erzeugt und dort außerdem das von den jeweiligen Basisgasen sich herleitende Plasma plaziert. Das Substrat 4 wird dabei aufgeheizt und bevorzugt auf Temperaturen zwischen 700 und 800 °C gehalten, wozu auf der rückwärtigen Seite des Substrats eine Kühlung mit einer Kühlmittelzu- und -abfuhr 40, 41 vorgesehen ist. Die Kühlung ist dabei vorteilhaft mit einem tiefkalten Flüssiggas, beispielsweise Flüssigargon oder Flüssigstickstoff, auszuführen. Das über die Leitung 8 und letztlich über deren Enddüse 8' in die Plasmazone einzuleitende, dreifachbindige KW-Gas wird mit dem durch den Plasmabrenner erzeugten Plasmastrom schließlich auf das gekühlte Substrat befördert und bildet dort die Diamantschicht aus. Im vorliegenden Beispiel kann als Substrat - aufgrund des hier angewandten, relativ heißen Plasmabildungsprozesses mit einem Plasmabrenner - lediglich ein relativ hitzebeständiger Werkstoff verwendet werden, beispielsweise Wolfram, während bei Verfahrensvarianten mit geringerem Energieeintrag, z.B. mit einem Gleichstromentladungsplasma, ein breiteres Spektrum an Substraten, beispielsweise auch Halbleitermaterialien, eingesetzt werden können.

Erfindungsgemäß und demzufolge auch gemäß dem in der Figur 1 gezeigten Anlagenbeispiel ist des weiteren die Versorgung des Prozesses mit den einzelnen Prozeßgasen und insbesondere die spezielle Zuleitung des dreifachbindigen KW-Gases, hier Acetylen, wesentlich. Hierzu sind beispielgemäß die Gasspeicher 31 für Argon, vorzugsweise ein Flüssigargontank, 32 für Wasserstoff und 33 für Acetylen, die abgehenden Versorgungsleitungen 38,18,18b und 19 sowie die - als Black Box 50 dargestellte Acetylen- oder Acetylen-Wasserstoff-Versorgung der Kammer 1 vorgesehen. Daran schließen sich femer die schon genannten, zur Vakuumkammer 1 führenden Zuleitungen 9,7 und 8 - gegebenenfalls über weitere, zwischengeschaltete Elemente - an. Schließlich sind die der Versorgung des Plasmabrenners mit Gas dienenden, von den Leitungen 9 und 7 abzweigenden, in die Plasmagasleitung 6 mündenden Zweigleitungen 9a und 7a zu nennen sowie alle standardmäßigen Schalt- und Regelglieder, die in allen Haupt- und Zweigleitungen angeordnet sind und deren Funktion ohne weitere Ausführungen aus der in Figur 1 angewandten Symbolik klar wird.

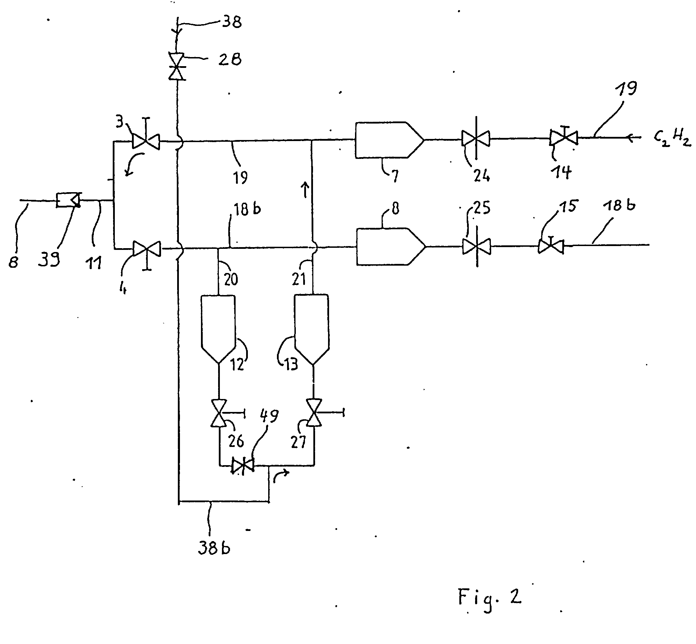

Die Acetylen- oder Acetylen/Wasserstoff-Versorgung des Diamantbildungsprozesses ist - wie mehrfach bereits angesprochen- mit besonderen Sicherheitseigenschaften auszubilden. Diese sind in der Figur 1 durch die Black Box 50 angedeutet. Eine mögliche Sicherheitsschaltung für die Zufuhr des KW-Gases zur Kammer 1 ist beispielsweise aus der DE-OS 38 25 721 zu entnehmen, und ist in entsprechender Abwandlung in der anliegenden **Figur 2** nochmals detailliert dargestellt. Im einzelnen ist der Figur 2 entnehmbar, wie die Kammerzuleitung 8 mit den Versorgungsleitungen 19 und 18b über die in Figur 1 dargestellte Black Box 50 in Verbindung steht. Dazu sind in den Versorgungsleitungen 19 und 18b Druckregler 14 und 15, Hauptschaltventile 24 und 25 und - stromabwärts davon - Rückschlagventile 7,8 angeordnet. In die Versorgungsleitungen 19 und 18b münden stromabwärts der Rückschlagventile 7, 8 Inertgasleitungen 21, 20, wobei sich in diesen Inertgasleitungen vor deren Einmündung ebenfalls Rückschlagventile 13, 12 sowie Druckregler 27, 26 befinden. Die beiden Inertgasleitungen 20, 21 münden stromaufwärts schließlich beide in die Hauptzuleitung 38b für das steuemde Inertgas ein, wobei in dem nicht für die Acetylenzufuhr zuständigen Leitungszweig 20 vor dem Anschluß an die Leitung 38b ein Schaltventil 49 installiert ist, mit dem dieser Leitungszweig zu- und abgeschaltet werden kann. Die Hauptzuleitung 38b wiederum ist an das Schaltventil 28 angeschlossen, dem Inertgas über die Versorgungsleitung 38 zufließt.

Ein möglicher Betriebsablauf bei der geschilderten Anlage ist wie folgt:

Nach Plazierung des Substrats 4 auf dem Halter 3 wird die Kammer 1 geschlossen und über den Gasabzug 2 beginnt der Abzug und die Verdrängung der Luft und insbesondere auch der Luftfeuchte aus der Kammer 1. Dies wird durch mehrfache Absaugung des Kammerinhalts mit anschließender Spülung der Kammer mit Argon über Leitung 7 und deren Schaltventil 30 sowie deren Regler 31 bewerkstelligt. Nach dieser Verdrängungsphase wird in der Kammer eine erste Behandlungsgasatmosphäre mit prozeßangepaßtem Druckniveau ( ca. 300 hPa (mbar)) installiert, wobei diese entweder zunächst eine reine Argonatmosphäre oder bereits eine Mischatmosphäre aus Argon und Wasserstoff sein kann und wobei der Wasserstoff über Leitung 9 in geeigneter Menge zudosierbar ist. Der Wasserstoffanteil der Kammeratmosphäre kann jedoch auch über den in der Kammer befindlichen Plasmabrenner 5 geregelt werden, da dieser ohnehin in der folgenden Prozeßphase einzuschalten und mit einem Ar-H2-Gemisch von beipielsweise 70 % Ar und 30 % H2 zu betreiben ist. Auf die eine oder andere Weise ist in der Kammer 1 eine Atmophäre bei etwa 200 bis 400 hPa (mbar) Druck und von etwa 30 % Wasserstoffgehalt aufzubauen, wobei das Substrat 4 bereits in dieser Phase durch das Ar-H2-Plasma des Plasmabrenner 5 aufgeheizt wird.

Sind auf dieser Basis stationäre Betriebszustände erreicht und insbesondere auch die passende Substrattemperatur eingestellt - günstigerweise etwa 600 bis 800°C - so kann zur Diamantschichtbildung mit der Einleitung von Acetylen - oder auch eines Acetylen-Wasserstoff-Gemisches - in das Plasma über die Düse 8' begonnen werden. Dabei muß die Düse 8' hinsichtlich Durchmesser und Länge derart ausgestaltet sein, daß die Ausströmgeschwindigkeit des Zumischgases größer ist als die Zündgeschwindigkeit des eingesetzten KW-Gases, hier also des Acetylens. Diese Zumischung wird femer mit der Schaltung, wie sie in Figur 2 dargestellt ist, äußerst vorteilhaft bewerkstelligt, wie im folgenden beschrieben:

Über Leitung 38b und 19 steht bei geöffnetem Hauptventil 28 anfänglich Argon am vor der Kammer 1 befindlichen Einlaßventil 39 an, wobei als Einlaßventil 39 aus Sicherheitsgründen bevorzugt ein selbstständig schließfähiges Kappenventil zur Anwendung kommt. Soll eine Acetylenzufuhr zur Plasmakammer erfolgen, so ist zunächst das Einlaßventil 39 und das Acetylenschaltventil 24 zu öffnen, worauf jedoch, aufgrund der geringfügig höheren Einstellung des Druckreglers 27 gegenüber dem Druckregler 14, das Rückschlagventil 7 in der Leitung 19 weiterhin geschlossen bleibt und also lediglich Argon und kein Acetylen in die Kammer 1 einfließt. Geeignete Druckeinstellungen der Druckregler 27 und 14 hierfür sind beipielsweise mit etwa 1000 hPa (1,0 bar) Argondruck und 900 hPa (0,9 bar) Acetylendruck gegeben (vorteilhafterweise soll der Druckunterschied zwischen den beiden Druckreglem zwischen 5 und maximal 20 % liegen). Zur endgültigen Einleitung der Acetyleneinspeisung ist schließlich das Hauptventil 28 für die Argonzufuhr zu schließen, wodurch aufgrund des Abfließens des Restargons aus dem vorderen Teil der Leitung 19 das Rückschlagventil 7 öffnet und der Acetylenzufluß beginnt. Auf diese Weise ergibt sich eine ohne sprunghafte Änderungen ablaufende Einschaltung der Acetylenzufuhr zur Kammer 1 und zu dem darin ausgebildeten, vom Plasmabrenner stammenden Plasmagasstrom. Die letztliche Mengendosierung des Acetylens erfolgt dabei über den in der Acetylenleitung 19 angeordneten Mengenregler 3, wobei hier - abhängig von Substrat-, Kammer- und Plasmabrennergröße - Werte von etwa 2 bis 10 Normalliter Acetylengaszufuhr pro Minute gängige Werte darstellen.

Diese Acetylengaszufuhr ist im folgenden solange aufrechtzuerhalten, bis auf dem jeweiligen Substrat die jeweils gewünschte Schicht an Diamant gebildet ist. Dies beansprucht im geschilderten Beispielsfall - Diamantschicht auf Wolframsubstrateinen Zeitraum von ca. 10 bis 60 Minuten - je nach gewünschter Schichtdicke. Nach Vollendung der gewünschten Schicht ist die Acetylenzufuhr wieder abzustellen. Dies wird dadurch in geeignet "sanfter" Weise erreicht, daß das Hauptventil 28 für die Inertgaszufuhr - sprich Argonzufuhr - wieder auf "Offen" geschaltet wird und daher das Argon mit dem wie oben festgelegten Druckwert wieder in die Leitung 19 einfließt und nach kurzer Zeit das Rückschlagventil 7 auslöst und somit die Acetylenzufuhr beendet. Auf diese Weise wird ein sicherer Abschaltvorgang des Acetylenstroms erzielt und damit letztlich auch die Beendigung des gesamten Abscheidungsprozesses eingeleitet. Dazu ist im folgenden noch die Abschaltung des Plasmabrenners, die Abkühlung des beschichteten Substrats, die Einstellung der sonstigen Gaseinleitungen und die Belüftung der Kammer 1 auszuführen.

Neben der eben geschilderten Schaltung des Acetylens ist mit der in Figur 2 gezeigten Vorrichtung auch die sichere Schaltung und Zuleitung eines acetylenhaltigen Gasgemisches, beispielsweise eines Gemisches aus Acetylen und Wasserstoff, zur Plasmakammer 1 problemlos ausführbar. Hierzu wird der Mischpartner des Acetylens in gleicher Weise wie das Acetylen selbst geschaltet, wobei dies - wie man ohne weiteres erkennt - mit dem, in Figur 2 ebenfalls gezeigten, zweiten Zuleitungsast 18b und den zugehörigen Einstellgliedern problemlos ausführbar ist.

Das erläuterte, allerdings nicht auf das beschriebene Beispiel beschränkte Verfahren zur Herstellung einer Diamantschicht mittels eines eine Dreifachbindung enhaltenden Kohlenwasserstoffgases liefert - im Vergleich zu vorbekannten Verfahren auf der Basis von Methan und dergleichen - eine schnellere Abscheidung der Schichten und darüber hinaus häufig auch verbesserte Schichtqualitäten.

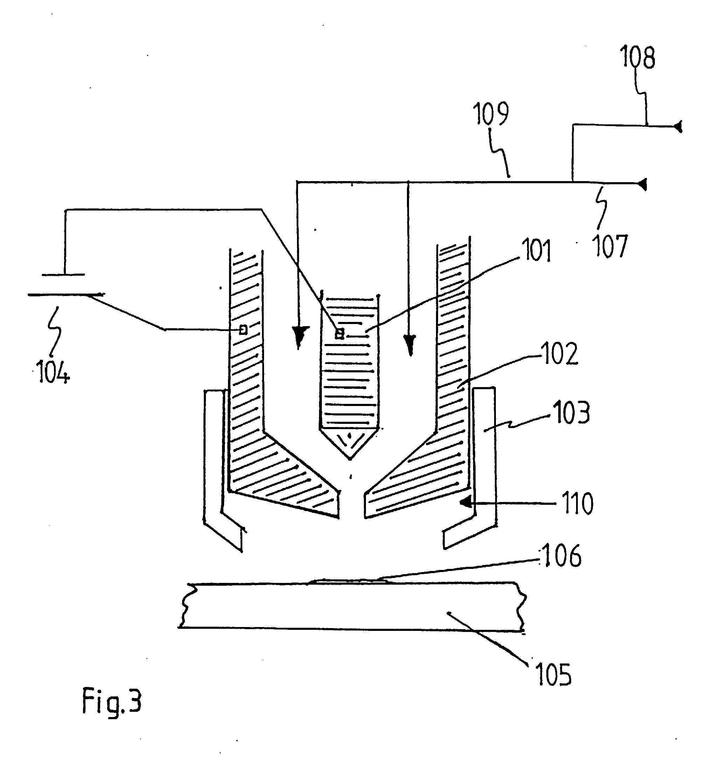

Im Anschluß soll anhand **Figur 3** ein weiteres Beispiel einer Diamantabscheidung mittels eines sogenannten Plasma-Jets erläutert werden: In der Figur ist schematisch eine Elektrodenanordnung bestehend aus einer zylindrischen, spitz zulaufenden Elektrode 101, die von einer wassergekühlten Düse 102 umgeben ist, dargestellt. Elektrode 101 und Düse 102 sind mit einer Spannungsquelle 104 verbunden. Über Leitung 109 wird ein Gasstrom zwischen die Elektrode 101 und die Düse 102 geleitet, in dem es im Bereich hoher Feldstärken zwischen der Elektrodenspitze und dem Düsenkopf zu einer Bogenentladung kommt, die als Lichtbogen sichtbar wird. Der aus der Düse 102 austretende Plasma-Jet (ca. 5000°C) trifft auf das Substrat 105, das auf Temperaturen um die 1000°C gekühlt wird. Dort schlägt sich eine Diamantschicht 106 nieder, wobei die Wachstumsrate etwa 900 µm pro Stunde beträgt. Der Umgebungsdruck kann zur Steigerung der Abscheiderate bis auf atmosphärischen Druck erhöht werden.

Vorteilhaft ist hierbei, wenn die Elektrodenanordnung von einer Außenabschirmung 103 umgeben ist. Zwischen Düse 102 und dieser Außenabschirmung 103 kann dann ein Außenschutzgas über Leitung 110 geleitet werden. Dieses Außen-schutzgas dient der Abschirmung der Umgebungsatmosphäre einerseits, zum anderen kann durch Zusatz von Wasserstoff (oder Sauerstoff) bewirkt werden, daß bei der Diamantbildung entstehender amorpher Kohlenstoff und Graphit weggeätzt werden.

Günstig bei diesem Verfahren ist die Möglichkeit der genau dosierbaren Zugabe von beispielsweise Acetylen in Argon in die Leitung 108 mittels einer Mischeinrichtung. Bei Mengen von 100 bis 200 ppm Acetylen erhält man gute Schichtergebnisse und der Elektrodenabbrand wird weitgehend minimiert. Zusätzlich läßt sich über Leitung 107 in einen Argonstrom eine genau bemessene Menge Sauerstoff von wenigen ppm (oder Wasserstoff) zudosieren.

Mit dem geschilderten Verfahren werden Diamantschichten hoher Qualität und mit hoher Geschwindigkeit hergestellt.

## Patentansprüche

1. Verfahren zur Herstellung von Diamantschichten, bei dem die Diamantschicht auf einem Substrat mittels eines durch Energieeintrag erzeugten Plasmas aus einem Basisgas, das zumindest Wasserstoff und ein eine Dreifachbindung enthaltendes Kohlenwasserstoffgas, (Alkingas), insbesondere Acetylen, sowie optionsweise zusätzlich auch Edelgas enthält, gebildet wird, wobei dieser Bildungsprozeß bei einem Gasdruck von 0,05 hPa (mbar) bis atmosphärischen Druck, vorzugsweise bei einem Gasdruck von 0,05 bis 500 hPa (mbar), und bei einer Temperatur des Substrats von 300 bis 1000°C ausgeführt wird, **dadurch gekennzeichnet,** daß die Zumischung des die Dreifachbindung enthaltenden Kohlenwasserstoffgases zum Basisgas oder einem Anteil des Basisgases innerhalb der Kammer oder in der Zuleitung zur Kammer von einer vorausgehenden und einer nachfolgenden Inertgaszumischung begleitet ausgeführt wird, wobei die Umschaltung zwischen Inertgaszumischung und Kohlenwasserstoffgaszumischung in einem weichen, nicht plötzlich erfolgenden Wechsel insbesondere ohne wesentlichen Drucksprung erfolgt.

2. Verfahren nach Anspruch 1, dadurch gekennzeichnet, daß die Diamantschicht auf dem Substrat mittels eines mit einem Lichtbogen erzeugten Plasmas, vorzugsweise mittels eines mit einem Lichtbogen erzeugten und auf das Substrat gerichteten Plasmagasstromes, gebildet wird, wobei ein Umgebungsdruck von 100 bis 500 hPa (mbar) eingestellt wird.

3. Verfahren nach Anspruch 2, dadurch gekennzeichnet, daß der Plasmagasstrom aus einem oder mehreren Gasströmen gebildet wird.

4. Verfahren nach Anspruch 3, dadurch gekennzeichnet, daß ein Gasstrom aus einem der Gruppe der Edelgase entnommenen Trägergas, wie Argon und/oder Helium und/oder Neon, mit 100 bis 200 ppm Acetylen gebildet wird.

5. Verfahren nach Anspruch 3 oder 4, dadurch gekennzeichnet, daß der Plasmagasstrom aus zwei Gasströmen gebildet wird, die als Trägergas Argon und/oder Helium enthalten, dem Sauerstoff und/oder Wasserstoff bzw. ein Alkingas, insbesondere Acetylen, zugesetzt wird.

6. Verfahren nach einem der Ansprüche 3 bis 5, dadurch gekennzeichnet, daß der Plasmagasstrom von einem Gasstrom bestehend aus Argon und/oder Helium mit Wasserstoff und/oder Sauerstoff umgeben wird.

7. Verfahren nach Anspruch 1, dadurch gekennzeichnet, daß die Diamantschicht auf einem Substrat mittels eines durch Gleichstromentladung erzeugten Plasmas aus einem Basisgas gebildet wird, wobei ein Druck von 0,05 bis 50 hPa (mbar) eingestellt wird.

8. Verfahren nach Anspruch 7, dadurch gekennzeichnet, daß das Basisgas aus Argon mit einem Anteil von 0,1 bis 1 Vol.-%, vorzugsweise bis 0,5 Vol.-%, Acetylen gebildet wird, dem gegebenenfalls Sauerstoff zugesetzt wird.

9. Verfahren nach Anspruch 1, dadurch gekennzeichnet, daß die Diamantschicht auf einem Substrat mittels eines durch elektromagnetische Wellen, insbesondere Mikro- oder Hochfrequenz-Wellen, erzeugten Plasmas aus einem Basisgas gebildet wird, wobei ein Druck von 0,05 bis 50 hPa (mbar) eingestellt wird.

10. Verfahren nach Anspruch 1, dadurch gekennzeichnet, daß die Diamant-schicht auf dem Substrat mittels eines durch ein Laserschweißverfahren thermisch induzierten Plasmas aus einem Basisgas gebildet wird.

11. Verfahren nach einem der Ansprüche 1 bis 10, dadurch gekennzeichnet, daß das Basisgas 80 bis 25 Vol-% Argon, 20 bis 70 Vol-% Wasserstoff und bis zu 5 Vol-% Kohlenwasserstoffgas enthält.

12. Verfahren nach einem der Ansprüche 1 bis 11, dadurch gekennzeichnet, daß das Basisgas Helium enthält.

13. Verfahren nach den Ansprüchen 11 und 12, dadurch gekennzeichnet, daß bis zu 50 % des Argonanteils durch Helium ersetzt wird.

14. Verfahren nach einem der Ansprüche 1 bis 13, dadurch gekennzeichnet, daß in die der Kohlenwasserstoffgas (KW-Gas)-Zuleitung dienenden, mit einem Rückschlagventil ausgestatteten Versorgungsleitung und gegebenenfalls auch in die ebenfalls mit einem Rückschlagventil versehene Zuleitung für ein weiteres Gas stromabwärts der Rückschlagventile ein Inertgas derart eingeleitet wird, daß das Inertgas auf ein jeweils geringfügig höheres Druckniveau eingestellt ist als das in der jeweiligen Versorgungsleitung zugeführte Gas, wobei bei Beginn des Zumischvorgangs des Zumischgases zur Plasmakammer anfänglich die Inertgaszuleitung zu den Versorgungsleitungen offen geschaltet ist, diese jedoch nach kurzer Zeit durch die Schließung der Inertgaszuleitung beendet wird und auf diese Weise die KW-Gaszufuhr durch die sich öffnenden Rükschlagventile einsetzt, und bei dem die Abschaltung der KW-Gas-Zufuhr dadurch erfolgt, daß die besagte Inertgaszuleitung mit den besagten Druckverhältnissen wieder begonnen wird.

## Claims

1. Method for producing diamond layers, wherein the diamond layer is formed on a substrate by means of a plasma, generated by energy input, of a base gas which comprises at least hydrogen and a hydrocarbon gas containing a triple bond (alkyne gas), in particular acetylene, and optionally additionally also noble gas, said formation process being carried out at a gas pressure of from 0.05 hPa (mbar) to atmospheric pressure, preferably at a gas pressure of from 0.05 to 500 hPa (mbar), and at a temperature of the substrate of from 300 to 1000°C, **characterized in** that the admixture of the hydrocarbon gas containing the triple bond to the base gas or a fraction of the base gas is carried out within the chamber or in the feeder to the chamber, accompanied by a prior and a subsequent inert gas admixture, the switch-over between inert gas admixture and hydrocarbon gas admixture being effected in a smooth, not abrupt changeover, in particular without a significant pressure jump.

2. Method according to Claim 1, characterized in that the diamond layer is formed on the substrate by means of an arc-generated plasma, preferably by means of an arc-generated plasma gas stream directed onto the substrate, an ambient pressure of from 100 to 500 hPa (mbar) being set.

3. Method according to Claim 2, characterized in that the plasma gas stream is formed from one or more gas streams.

4. Method according to Claim 3, characterized in that a gas stream is formed from a carrier gas taken from the group of the noble gases, such as argon and/or helium and/or neon, with from 100 to 200 ppm of acetylene.

5. Method according to Claim 3 or 4, characterized in that the plasma gas stream is formed from two gas streams which, as the carrier gas, comprise argon and/or helium to which oxygen and/or hydrogen or an alkyne gas, in particular acetylene, is added.

6. Method according to any one of Claims 3 to 5, characterized in that the plasma gas stream is enclosed by a gas stream comprising argon and/or helium with hydrogen and/or oxygen.

7. Method according to Claim 1, characterized in that the diamond layer is formed on a substrate by means of a plasma, generated by means of a direct-current discharge, from a base gas, a pressure of from 0.05 to 50 hPa (mbar) being set.

8. Method according to Claim 7, characterized in that the base gas is formed from argon having a proportion of from 0.1 to 1 vol%, preferably up to 0.5 vol%, of acetylene, which may or may not be admixed with oxygen.

9. Method according to Claim 1, characterized in that the diamond layer is formed on a substrate by means of a plasma, generated by means of electromagnetic waves, in particular microwaves or radio-frequency waves, from a base gas, a pressure of from 0.05 to 50 hPa (mbar) being set.

10. Method according to Claim 1, characterized in that the diamond layer is formed on the substrate by means of a plasma, thermally induced by means of a laser welding process, from a base gas.

11. Method according to any one of Claims 1 to 10, characterized in that the base gas comprises from 80 to 25 vol% of argon, from 20 to 70 vol% of hydrogen and up to 5 vol% of hydrocarbon gas.

12. Method according to any one of Claims 1 to 11, characterized in that the base gas comprises helium.

13. Method according to Claims 11 and 12, characterized in that up to 50% of the argon fraction is replaced by helium.

14. Method according to any one of Claims 1 to 13, characterized in that introduction of an inert gas into the supply line which serves for supplying the hydrocarbon gas (HC gas) and is provided with a nonreturn valve, and optionally also into the feeder, likewise provided with a nonreturn valve, for a further gas, downstream of the nonreturn valves, is effected in such a way that the inert gas is set to a pressure level which in each case is slightly higher than that of the gas supplied in the respective supply line, the inert gas feeder to the supply lines initially, at the start of the admixture process of the admixture gas to the plasma chamber being set to an open position, but being terminated after a brief interval by the inert gas feeder being closed, thus causing the HC gas infeed via the opening nonreturn valves to commence, and the termination of the HC gas infeed being effected by said inert gas supply with said pressure conditions being reinitiated.

## Revendications

1. Procédé de fabrication de couches de diamant, lors duquel la couche de diamant est formée sur un substrat à partir d'un gaz de base par l'intermédiaire d'un plasma produit par une injection d'énergie, qui contient au moins de l'hydrogène et un gaz hydrocarboné contenant une liaison triple (gaz alcyne), en particulier de l'acétylène, ainsi qu'en option également en plus un gaz rare, ce processus de formation étant effectué à une pression de gaz allant de 0,05 hPa (mbar) jusqu'à la pression atmosphérique, de préférence à une pression de gaz allant de 0,05 à 500 hPa (mbar) et à une température du substrat de 300 à 1000°C, caractérisé en ce que le mélange du gaz hydrocarboné contenant la liaison triple au gaz de base ou à une partie du gaz de base est effectué, avec l'accompagnement d'un mélange de gaz inertes préalable et d'un mélange de gaz inertes subséquent, au sein de la chambre ou dans la conduite d'alimentation en direction de la chambre, le changement entre le mélange de gaz inertes et le mélange de gaz hydrocarboné se faisant en un changement progressif, n'ayant pas lieu de manière soudaine, en particulier sans saut substantiel de pression.

2. Procédé selon la revendication 1, caractérisé en ce que la couche de diamant est formée sur le substrat par l'intermédiaire d'un plasma produit à l'aide d'un arc électrique, de préférence par l'intermédiaire d'un courant gazeux de plasma, produit à l'aide d'un arc électrique et dirigé sur le substrat, une pression environnante de 100 à 500 hPa (mbar) s'établissant.

3. Procédé selon la revendication 2, caractérisé en ce que le courant gazeux de plasma est formé d'un ou de plusieurs courants gazeux.

4. Procédé selon la revendication 3, caractérisé en ce qu'un courant gazeux est formé à partir d'un gaz vecteur prélevé parmi le groupe des gaz rares, comme l'argon et/ou l'hélium et/ou le néon, avec de 100 à 200 ppm d'acétylène.

5. Procédé selon la revendication 3 ou 4, caractérisé en ce que le courant gazeux de plasma est formé de deux courants gazeux, qui contiennent, en tant que gaz vecteur, de l'argon et/ou de l'hélium, auquel est ajouté de l'oxygène et/ou de l'hydrogène, respectivement un gaz alcyne, en particulier de l'acétylène.

6. Procédé selon l'une quelconque des revendications 3 à 5, caractérisé en ce que le courant gazeux de plasma est entouré d'un courant gazeux se composant d'argon et/ou d'hélium avec de l'hydrogène et/ou de l'oxygène.

7. Procédé selon la revendication 1, caractérisé en ce que la couche de diamant est formée sur un substrat à partir d'un gaz de base par l'intermédiaire d'un plasma produit par une décharge de courant continu, une pression de 0,05 à 50 hPa (mbar) s'établissant.

8. Procédé selon la revendication 7, caractérisé en ce que le gaz de base est formé d'argon ayant une proportion de 0,1 à 1 % en volume, de préférence allant jusqu'à 0,5 % en volume d'acétylène, auquel on ajoute, le cas échéant, de l'oxygène.

9. Procédé selon la revendication 1, caractérisé en ce que la couche de diamant est formée sur un substrat à partir d'un gaz de base par l'intermédiaire d'un plasma produit par des ondes électromagnétiques, en particulier par des ondes hyperfréquence ou haute fréquence, une pression de 0,05 à 50 hPa (mbar) s'établissant.

10. Procédé selon la revendication 1, caractérisé en ce que la couche de diamant est formée sur le substrat à partir d'un gaz de base par l'intermédiaire d'un plasma induit de manière thermique par un procédé de soudage au laser.

11. Procédé selon l'une quelconque des revendications 1 à 10, caractérisé en ce que le gaz de base contient de 80 à 25 % en volume d'argon, de 20 à 70% en volume d'hydrogène et jusqu'à 5 % en volume de gaz d'hydrocarbures.

12. Procédé selon l'une quelconque des revendications 1 à 11, caractérisé en ce que le gaz de base contient de l'hélium.

13. Procédé selon l'une quelconque des revendications 11 et 12, caractérisé en ce que l'on remplace par de l'hélium jusqu'à 50 % de la proportion d'argon.

14. Procédé selon l'une quelconque des revendications 1 à 13, caractérisé en ce que l'on introduit un gaz inerte dans la conduite d'approvisionnement faisant fonction de conduite d'alimentation en gaz hydrocarboné (gaz HC), équipée d'un clapet de non-retour et, le cas échéant, également dans la conduite d'alimentation pourvue également d'un clapet de non-retour, pour un gaz supplémentaire en amont du clapet de non-retour, de telle manière que le gaz inerte soit réglé à un niveau de pression à chaque fois légèrement plus élevé que le gaz amené dans la conduite d'approvisionnement correspondante, la conduite d'alimentation en gaz inerte étant initialement branchée ouverte en direction des conduites d'approvisionnement au début de la procédure de mélange du gaz de mélange en direction de la chambre de plasma, celle-ci étant achevée cependant après une courte période par la fermeture de la conduite d'alimentation en gaz inerte, et l'apport de gaz HC débutant de cette manière à l'ouverture des clapets de non-retour, et lors duquel la coupure de l'apport de gaz HC se produit du fait que ladite cenduite d'alimentation en gaz inerte commence à nouveau avec lesdites conditions de pression.
